# EUROPÄISCHE PATENTSCHRIFT

(11) **EP 3 514 910 B1**
(45) Veröffentlichungstag und Bekanntmachung des Hinweises auf die Patenterteilung: **04.11.2026**
(21) Anmeldenummer: 18152603.9
(22) Anmeldetag: 19.01.2018
(51) Int. Cl.: H02J 3/38, H02P 9/00, H02J 3/44

(54) **VERFAHREN ZUM BETRIEB EINER WINDENERGIEANLAGE**
METHOD FOR OPERATING A WIND TURBINE
PROCÉDÉ DE FONCTIONNEMENT D'UNE ÉOLIENNE

(43) Veröffentlichungstag der Anmeldung: 24.07.2019
(73) Patentinhaber: KK Wind Solutions A/S, 7430 Ikast (DK); Nordex Energy SE & Co. KG, 22419 Hamburg (DE)
(72) Erfinder: Hoffmann, Nils, 06114 Halle/Saale (DE); Schall, Nils-Hendric, 14199 Berlin (DE); Genius, Andreas, 45470 Mülheim an der Ruhr (DE)
(74) Vertreter: Hauck Patent- und Rechtsanwälte PartmbB

(56) Entgegenhaltungen:
- US-A1- 2005 122 083
- US-A1- 2012 310 426

## Beschreibung

Die vorliegende Erfindung betrifft ein Verfahren zum Betrieb einer Windenergieanlage, die über einen Umrichter in ein elektrisches Versorgungsnetz elektrische Leistung synchronisiert zu einer Netzspannung einspeist.

Die Erfindung betrifft allgemein das Gebiet zur Regelung eines Umrichtersystems einer Windenergieanlage, insbesondere die Regelung eines Teilumrichters für einen doppelt gespeisten Asynchrongenerator. Für den Betrieb der Windenergieanlage ist die Regelung des Umrichters bei Vorliegen eines Netzfehlers eine besondere technische Herausforderung.

Aus EP 1 914 877 A2 ist ein Verfahren und eine Vorrichtung zum Betrieb einer elektrischen Maschine bekannt geworden. Die elektrische Maschine, hierbei kann es sich um eine Windenergieanlage handeln, ist dazu ausgelegt, elektrisch mit dem elektrischen Versorgungsnetz verbunden zu werden. Eine Steuerung ist für die elektrische Maschine vorgesehen, damit diese elektrisch mit dem Versorgungsnetz während und nach einem Spannungseinbruch für eine unbestimmte Zeitdauer verbunden bleibt. Insbesondere ist bekannt geworden, bei einem Abfall der Spannung auf nahezu Null Volt, *zero voltage ride through* (ZVRT), eine Phasenregelschleife vorzusehen, die einen Phasendetektor und mindestens einen proportional-integral (PI)-Filter aufweist. Ferner ist vorgesehen, dass die Parameter des PI-Filters in Abhängigkeit von netzspannungsabhängig definierten Zuständen gesetzt und diskret ausgewählt werden können, wobei hierzu auf eine Zustandsmaschine zurückgegriffen wird.

Aus US 9,641,113 B2 ist bekannt, eine Windenergieanlage mit einem doppelt gespeisten Asynchrongenerator über eine Phasenregelschleife zu regeln. Bei bestimmten Ereignissen im Netz und/oder in der Windenergieanlage kann es passieren, dass die Phasenregelschleife zeitweise nicht synchron mit der Netzspannung ist. Bekannte Windenergieanlagen erlauben der Phasenregelschleife in diesem Fall, das Ereignis zu durchfahren und erst zu einem späteren Zeitpunkt wieder synchron mit der Netzspannung einzuspeisen. Damit die Phasenregelschleife schnell wieder synchronisiert werden kann, wird eine Phasenwinkelabweichung ermittelt und bei Überschreiten eines Mindestwerts aus dieser ein Skalierungsfaktor berechnet, der auf die Sollwerte der einzuspeisenden Ströme angewendet wird.

Aus US 2005/0122083 A1 ist eine Windenergieanlage bekannt geworden, die im Falle eines transienten Spannungseinbruchs bei Restspannungen bis 5% der Nennspannung während des Netzfehlers netzsynchron betrieben werden kann. Hierzu ist ein Sensor vorgesehen, der eine Spannung einer einzelnen Phase im Versorgungsnetz während eines Fehlers misst. Ein Steuerungssystem ist mit dem Sensor verbunden und steuert den Umrichter an. Das Steuersystem synthetisiert aus Wellenformvorlagen für die drei Phasen auf Basis einer Phasenspannung in einer Phase den einzuspeisenden Strom und speist diesen in das Netz ein.

Der Erfindung liegt die Aufgabe zugrunde, ein Verfahren zum Betrieb einer Windenergieanlage bereitzustellen, das mit einfachen Mitteln auch bei transienten Spannungsfehlern in dem elektrischen Versorgungsnetz eine zuverlässige und dynamische Nachführung des Phasenwinkels erlaubt und dabei ein sprunghaftes Verhalten vermeidet. Weiterhin soll ein Verfahren angegeben werden, dass einen stabilen Betrieb der Windenergieanlage über den gesamten Spannungsbereich erlaubt.

Erfindungsgemäß wird die Aufgabe durch das Verfahren mit den Merkmalen aus Anspruch 1 gelöst. Vorteilhafte Ausgestaltungen bilden die Gegenstände der Unteransprüche.

Das erfindungsgemäße Verfahren ist vorgesehen und bestimmt zum Betrieb einer Windenergieanlage, die über einen Umrichter in ein elektrisches Versorgungsnetz elektrische Leistung synchronisiert zu einer Netzspannung einspeist. Beispielsweise kann dies eine mit einer doppelt gespeisten Asynchronmaschine ausgestattete Windenergieanlage sein, die über einen Teilumrichter einspeist. Das erfindungsgemäße Verfahren greift auf einen in dem elektrischen Versorgungsnetz gemessenen Phasenwinkel und eine in diesem gemessene Spannung zurück. Das in seiner Phasenlage auf die Netzspannung und deren Phase abgestimmte Einspeisen erfolgt über eine Phasenregelschleife, an der der gemessene Phasenwinkel aus dem elektrischen Versorgungsnetz anliegt und die einen korrigierten Phasenwinkel zur Ansteuerung des Umrichters ausgibt. Bei dem erfindungsgemäßen Verfahren wird mindestens ein Parameter der Phasenregelschleife abhängig von dem gemessenen Amplitudenwert der Spannung im elektrischen Versorgungsnetz bestimmt. Dies erlaubt es, das Verhalten der Phasenregelschleife spannungsabhängig zu bestimmen und den mindestens einen Parameter an der Phasenregelschleife einzustellen. Auf diese Weise wird das Verhalten der Phasenregelschleife spannungsabhängig eingestellt und kann so gut an einen Spannungseinbruch im Netz angepasst werden, ohne dass die Phasenregelschleife ihre Dynamik für den regulären Betrieb ändert. Die Erfindung ermöglicht ein Durchfahren eines tiefen Netzspannungsfehlers, wobei die Windenergieanlage mit dem Netz verbunden bleibt und ohne dabei die Regelungsdynamik der Phasenregelschleife im Nennbetrieb der Windenergieanlage negativ zu beeinflussen. Ist für den Nennbetrieb der Windenergieanlage beispielsweise eine hohe Dynamik bei der Leistungseinspeisung der Windenergieanlage entsprechend von Netzfrequenzschwankungen gewünscht, so kollidiert dies nicht mit einem großen Beharrungsvermögen der Phasenregelschleife bei einem Spannungseinbruch, insbesondere nicht bei einem Spannungseinbruch von Null Volt oder nahezu Null Volt, *zero voltage ride through* (ZVRT).

In einer bevorzugten Ausgestaltung wird der mindestens eine Parameter, der spannungsabhängig bestimmt wird, so ausgewählt, dass er die Dynamik der Phasenregelschleife bestimmt. Hierbei ist die Spannungsabhängigkeit dergestalt gewählt, dass zum Beispiel bei einer niedrigen gemessenen Spannung die Dynamik der Phasenregelschleife angepasst wird. Hierdurch ist es möglich, die Dynamik der Phasenregelschleife nach Bedarf spannungsabhängig anzupassen. Dadurch ist z.B. sowohl ein hochdynamischer Betrieb der Phasenregelschleife im regulären Betrieb wie auch ein Betrieb mit verlangsamter Dynamik im Falle eines Spannungseinbruchs möglich.

In einer bevorzugten Ausgestaltung wird bei einer gemessenen Spannung unterhalb eines Schwellwerts der mindestens eine Parameter einen Wert annehmen, mit dem die Phasenregelschleife den zuletzt geregelten Phasenwinkel konstant hält. Die Phasenregelschleife friert auf einen konstanten Wert ein, der vor dem Spannungseinbruch als geregelter Phasenwinkel an dem Umrichter anlag. Der Schwellwert kann dabei bevorzugt eingestellt oder durch Auswahl der Funktion/Kennlinie parametrisiert sein.

Bei der vorliegenden Erfindung erfolgt der Aufbau der Phasenregelschleife mit einem proportionalen Schleifenfilter, der einen Verstärkungsfaktor K_{P} aufweist. Der Wert des Verstärkungsfaktors K_{P} wird spannungsabhängig bestimmt. Die Dynamik der Phasenregelschleife kann spannungsabhängig von der Proportionalitätskonstanten K_{P} und/oder der Zeitkonstanten T₁ bestimmt werden. Auch kann die Phasenregelschleife eine Vorsteuerung der Netzfrequenz aufweisen, die einen Tiefpassfilter mit einer Zeitkonstanten T₁ aufweist, deren Wert spannungsabhängig bestimmt wird.

Die Zeitkonstante T₁ wird bevorzugt im Fall eines Netzfehlers auf einen sehr großen Wert erhöht, so dass die Phasenregelschleife einen nahezu konstanten Wert für den korrigierten Phasenwinkel ausgibt.

Der Verstärkungsfaktor K_{P} wird bevorzugt im Fall eines Netzfehlers auf einen Wert von etwa Null abgesenkt, so dass die Phasenregelschleife einen nahezu konstanten Wert für den korrigierten Phasenwinkel ausgibt.

Für den Netzfehler können ein oder mehrere unterschiedliche Kriterien definiert sein. Ein Kriterium für einen besonders starken Spannungseinbruch liegt dann vor, wenn die Spannung auf einen Wert unterhalb eines Schwellwerts fällt. Dieser Fall umfasst auch einen Spannungseinbruch auf Null und auf nahezu Null Volt, bei dem die Netzspannung zusammenbricht.

Bevorzugt ist der mindestens eine Parameter stetig von der Spannung abhängig. Damit wird stetig jedem Spannungswert zwischen einem Spannungswert im Falle des Netzfehlers und der Nennspannung oder noch darüber hinaus ein Wert für den Parameter zugewiesen, wobei im Falle des Netzfehlers ein konstanter Wert für den geregelten Phasenwinkel und im Falle der Nennspannung eine vorbestimmte Dynamik für die Phasenregelschleife sich einstellt. Bevorzugt verläuft der mindestens eine Parameter stetig zwischen einem Minimal- und einem Maximalwert, beispielsweise in Form einer Sättigungskurve. In einer bevorzugten Weiterbildung nimmt der Wert des mindestens einen Parameters seine Werte proportional, bevorzugt annähernd linear zwischen zwei Wendepunkten, abhängig von dem Spannungswert an.

Die Erfindung wird nachfolgend an einem Beispiel näher erläutert. Es zeigen:
- Fig. 1: eine Windenergieanlage in einer schematischen Ansicht,
- Fig. 2: den beispielhaften elektrischen Aufbau einer an ein elektrisches Versorgungsnetz gekoppelten Windenergieanlage in einem Windpark,
- Fig. 3: eine Phasenregelschleife (PLL) zur kontinuierlichen Bestimmung des Phasenwinkels in Abhängigkeit von der Netzspannung,
- Fig. 4: Beispiele für eine mögliche Abhängigkeit der PLL-Parameter von der Mitsystemspannung und
- Fig. 5: das zeitliche Verhalten einer beispielhaften Phasenregelschleife (PLL) beim Auftreten eines tiefen Spannungsfehlers.

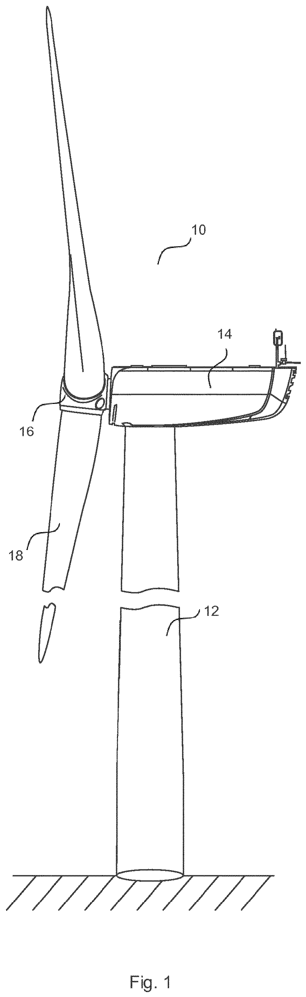

Figur 1 zeigt eine Windenergieanlage 10 mit einem Turm 12 und einem darauf angeordneten Maschinenhaus 14. Das Maschinenhaus 14 trägt einen Rotor 16 mit seinen Rotorblättern 18.

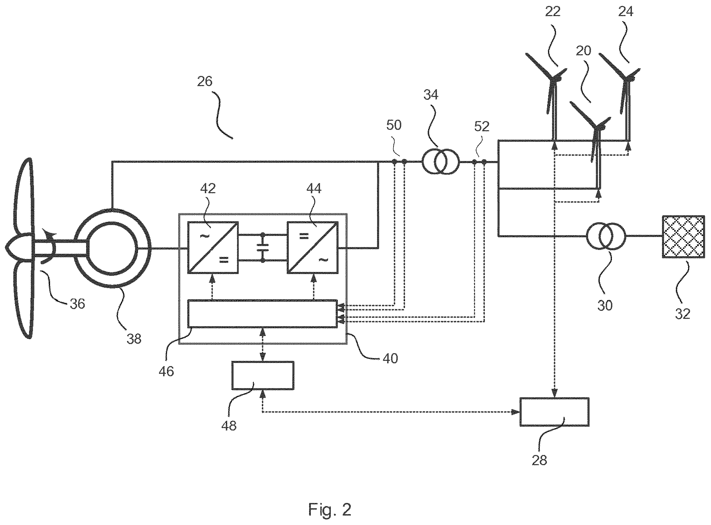

Figur 2 zeigt einen Windpark mit einer Vielzahl von Windenergieanlagen 20, 22, 24, 26, die von einem Windparkregler 28 geregelt werden. Der Windparkregler 28 ist dabei zu einem bidirektionalen Datenaustausch mit den Windenergieanlagen 20 bis 26, beziehungswiese deren Reglern, ausgebildet. Die Windenergieanlagen 20 bis 26 speisen in ein gemeinsames Parknetz ein, das über einen Kopplungspunkt 30 ein elektrisches Versorgungsnetz 32 speist. Die Windenergieanlagen 20 bis 26 speisen jeweils über einen Mittelspannungstransformator 34, beispielhaft dargestellt für die Windenergieanlage 26, in das Parknetz ein.

Die Windenergieanlage 26 ist als eine doppelt gespeiste Asynchronmaschine dargestellt. Der Rotor 36 treibt über einen Antriebsstrang (nicht im Detail dargestellt) den Rotor eines Generators 38 an. Der Rotorkreis des Generators 38 ist über ein Umrichtersystem 40 mit dem Transformator 34 und dem elektrischen Versorgungsnetz 32 verbunden. Der Statorkreis des Generators 38 ist direkt mit dem Transformator 34 und dem elektrischen Versorgungsnetz 32 verbunden. Das Umrichtersystem 40 besitzt einen rotorseitigen Umrichter 42 und einen netzseitigen Umrichter 44, die über einen Gleichstromzwischenkreis miteinander verbunden sind. Geregelt werden die Umrichter 42 und 44 von einem Umrichterregler 46.

Die gesamte Windenergieanlage 26 wird über einem Windenergieanlagenregler 48 geregelt, der zur Regelung bidirektional Daten mit dem Windparkregler 28 austauscht. An dem Umrichterregler 46 liegen eine Reihe von Eingangsgrößen an. Als Eingangsgrößen können Messwerte oder aus den Messwerten abgeleitete Werte an dem Umrichterregler 46 anliegen. Die für die Regelung benötigten Messgrößen können entweder anlagenseitig von dem Transformator 34 durch Sensoren 50 oder netzseitig des Transformators 34 durch Sensoren 52 gemessen werden. Als Messgrößen werden beispielsweise die Spannung und Ströme auf den einzelnen Phasen des Systems erfasst. Die Verarbeitung der Messwerte kann durch die Sensoren 50, 52 selbst oder in dem Umrichterregler 46 erfolgen. Die Sensoren 50, 52 sind so eingerichtet, dass sie dem Umrichterregler 46 für die Weiterverarbeitung geeignete Messdaten oder daraus abgeleitete Daten zur Verfügung stellen. Zur Synchronisation auf das elektrische Versorgungsnetz liegen nach der Verarbeitung der Messdaten im Umrichterregler 46 als Eingangsgrößen für die nachfolgend beschriebene Phasenregelungsschleife (PLL) wenigstens ein Phasenwinkel φₗᵢₙₑ und eine Mitsystemspannung U_{LV}+ (Positive Sequence Voltage) vor. Die Eingangsgrößen können auf bekannte Weise aus den Messgrößen ermittelt werden.

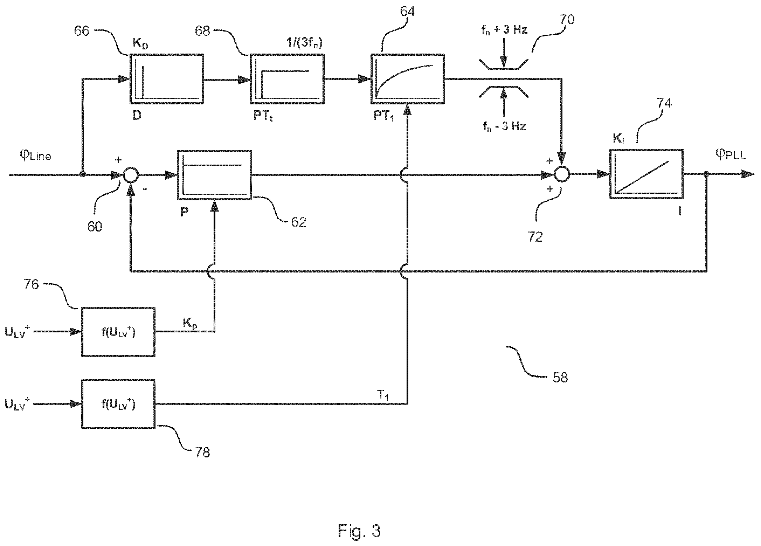

Figur 3 zeigt eine beispielshafte Phasenregelschleife (PLL) 58, welche zur kontinuierlichen Bestimmung eines für die Regelung des Umrichters 40 heranzuziehenden korrigierten Phasenwinkels φ_{PLL} abhängig von der anliegenden Mitsystemspannung U_{LV}+ und dem gemessenen Phasenwinkel φₗᵢₙₑ eingerichtet ist. Die Phasenregelschleife 58 in dem Ausführungsbeispiel gemäß Figur 3 ist als Teil der Regelungssoftware des Umrichterreglers 46 ausgeführt. Hierzu im Einzelnen:
Der gemessene Phasenwinkel φₗᵢₙₑ liegt zusammen mit dem korrigierten Phasenwinkel φ_{PLL} an einem Differenzglied 60 an, der eingerichtet ist, eine Phasenwinkeldifferenz Δφ aus dem gemessenen Phasenwinkel φₗᵢₙₑ und dem korrigierten Phasenwinkel φ_{PLL} zu bilden. Der korrigierte Phasenwinkel φ_{PLL} kann im regelungstechnischen Sinne als ein Sollwert für den netzsynchronen Betrieb des Umrichters 40 verstanden werden. Die in dem Differenzglied 60 gebildete Differenz Δφ kann im regelungstechnischen Sinne als eine Regelgröße angesehen werden. Die Phasenwinkeldifferenz Δφ liegt an einem Proportionalglied (P-Glied) 62 an und wird mit einem Faktor K_{P} spannungsabhängig verstärkt. Der entsprechende Verstärkungsfaktor K_{P} wird durch einen Berechnungsblock 76 spannungsabhängig vorgegeben und liegt als Eingangsgröße an dem P-Glied 62 an.

Der gemessene Phasenwinkel φ_{Line} liegt in einem parallel laufenden Ast an einem Differentialglied (D-Glied) 66 an, das eingerichtet ist, aus dem gemessenen Phasenwinkel φ_{Line} die Netzkreisfrequenz ω zu bestimmen. Die Netzkreisfrequenz liegt als Eingangssignal an einem Totzeitglied (PTt-Glied) 68 an, das eingerichtet ist, die Netzfrequenz verzögert für die Berechnung des Phasenwinkels bereitzustellen. Die Verzögerung des Totzeitglieds kann optional eingestellt werden. Bevorzugt kann die Verzögerung so vorgegeben werden, dass im Falle eines Netzfehlers nicht eine durch den Fehler gestörte Netzfrequenz, sondern die Netzfrequenz vor Fehlereintritt in die Bestimmung des Phasenwinkels eingeht. In dem angegebenen Ausführungsbeispiel verzögert das Totzeitglied kontinuierlich die zur Berechnung des Phasenwinkels genutzte Netzfrequenz um die Zeit, welche drei Netzperioden entspricht. Das Ausgangssignal des PTt-Glieds 68 liegt an einem Verzögerungsglied (PT₁-Glied) 64 an. Das PT₁-Glied 64 besitzt ein proportionales Übertragungsverhalten zusammen mit einer Verzögerung erster Ordnung. Der entsprechende Parameter T₁ für die Verzögerung wird durch einen Berechnungsblock 78 spannungsabhängig vorgegeben und liegt als Eingangsgröße an dem PT₁-Glied 64 an. Der Ausgang des PT₁-Gliedes 64 liegt an einem optionalen, einstellbaren Frequenzbegrenzer 70 an, der positive und negative Frequenzabweichungen begrenzt.

Der Ausgang des Parallelastes mit den Gliedern 64, 66, 68 und 70 liegt zusammen mit dem Ausgang des P-Glieds 62 an einem Summationsglied 72 an. Die Summe aus dem verstärkten gemessenen Phasenwinkel und der gefilterten Netzkreisfrequenz wird über ein Integrationsglied (I-Glied) 74 zu dem korrigierten Phasenwinkel φ_{PLL} integriert. In dem I-Glied ist dafür eine Integrationskonstante K_{I} vorgegeben. Der Phasenwinkel φ_{PLL} wird zur Ansteuerung der Schaltelemente des Umrichters 40 bereitgestellt.

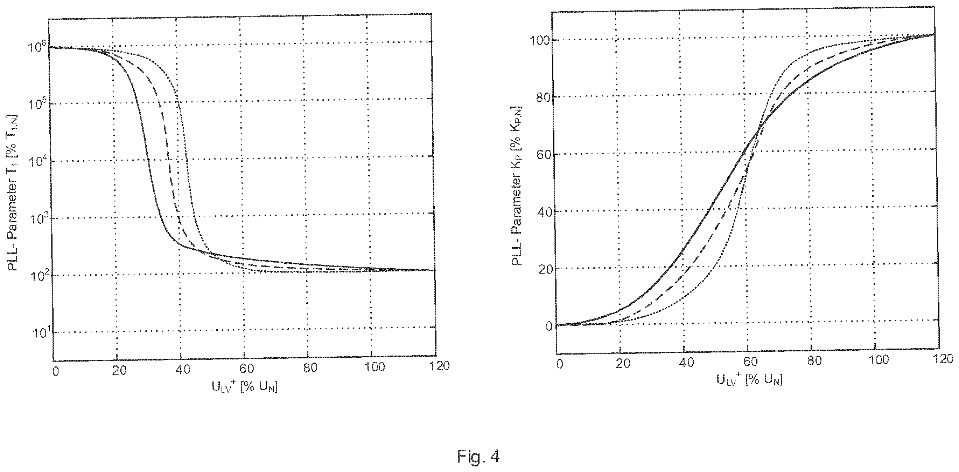

Die Berechnungsblöcke 76 und 78 der in Figur 3 dargestellte PLL 58 sind eingerichtet, die PLL-Parameter K_{P} und T₁ in Abhängigkeit von der Mitsystemspannung U_{LV}+ zu bestimmen, die als Eingangsgröße an den beiden Blöcken anliegt. Zur Bestimmung der PLL-Parameter sind in den Blöcken Funktionen bzw. Kennlinien abhängig von der Mitsystemspannung U_{LV}+ vorgegeben. Die beiden Funktionen bzw. Kennlinien sind in Figur 3 symbolisch durch die Funktionen f(U_{LV}⁺) gekennzeichnet. Die Kennlinien sind als Funktionen in Abhängigkeit von der Netzspannung vorgegeben. Alternativ können die Kennlinien auch in Form einer Wertetabelle vorgegeben sein, die den Kennlinienverlauf durch eine Vielzahl von Wertepaaren der Netzspannung und des jeweiligen PLL-Parameters vorgeben. Für die Funktionen f (U_{LV}⁺) kann vorgesehen sein, eine lineare Funktion oder eine nicht lineare Funktion zu betrachten. Hierzu näheres bei der Erläuterung von Figur 4.

Die Funktionen f sind bevorzugt von einer Gestalt, dass in einem oberen Bereich um Werte für die Mitsystemspannung von 100%, bezogen auf den Nennwert der Mitsystemspannung U_{LV}⁺, im Wesentlichen konstante Werte für die Regelparameter K_{P} und T₁ vorliegen. Der obere Bereich ist beispielsweise um Werte von 90% bis 115% des Nennwerts der Mitsystemspannung definiert. Die obere Grenze dieses Bereichs kann beispielsweise einem maximalen Wert für die Mitsystemspannung entsprechen, bei dem die Windenergieanlage im Falle eines Netzspannungsfehlers zumindest zeitweise noch betrieben werden kann. Die Funktionen sind weiterhin bevorzugt so vorgegeben, dass in einem unteren Bereich um Werte für die Mitsystemspannung von 0%, bezogen auf den Nennwert der Mitsystemspannung, im Wesentlichen konstante Werte für die Regelparameter K_{P} und T₁ vorliegen. Der untere Bereich kann zum Beispiel bei Prozentwerten von 0 bis 15% liegen. Abhängig von dem elektrischen Versorgungsnetz, in das die Windenergieanlage einspeisen soll, kann der untere Bereich jedoch auch breiter, z.B. von 0 bis 30%, oder schmaler, z.B. von 0 bis 5% gewählt werden. Der Kurvenverlauf zwischen dem unteren Bereich und dem oberen Bereich kann abhängig von Eigenschaften des Einspeisenetzes vorgegeben werden. Der Zusammenhang sollte aber mindestens so sein, dass die Funktionen über den gesamten Definitionsbereich stetig und über den gesamten relevanten Bereich monoton fallend oder monoton steigend sind. Bevorzugt ist auch ein glatter Verlauf, also eine stetige erste Ableitung der Funktionen von Vorteil.

In einer besonders bevorzugten Weiterbildung sind die Funktionen in Abhängigkeit weiterer Netzgrößen wie beispielweise einer Netzimpedanz, eines Netzkurzschlussstromes, Frequenzgradienten oder niederfrequenten Spannungsoberschwingungen vorgegeben, die als Variablen in den Funktionen berücksichtigt werden und die dafür als Eingangsgrößen an den Berechnungsblöcken 76 und 78 anliegen. In einer weiteren bevorzugten Weiterbildung sind in den Berechnungsblöcken 76 und 78 eine Vielzahl von Kennlinien und/oder Funktionen für die Bestimmung der PLL-Parameter K_{P} und T₁ vorgegeben, aus denen in Abhängigkeit von an den Blöcken anliegenden Stellsignalen geeignete Kennlinien zur Bestimmung der PLL-Parameter K_{P} und T₁ ausgewählt werden können. Die Vielzahl von Kennlinien und/oder Funktionen sind dazu jeweils einem entsprechenden Stellsignalwert für die anliegenden Eingangssignale zugeordnet. Die Berechnungsblöcke 76 und 78 können für die Auswahl der Kennlinien/Funktionen über einen Kennlinienwähler verfügen, der eingerichtet ist, in Abhängigkeit von den Stellsignalen und deren Signalwerten entsprechend der Zuordnung jeweils eine Kennlinie zur Bestimmung des PLL-Parameters K_{P} und eine Kennlinie zur Bestimmung des PLL-Parameters T₁ auszuwählen. Die Stellsignale werden dabei bevorzugt von einem dem Umrichterregler 46 übergeordneten Regler bereitgestellt, beispielsweise können der Windenergieanlagenregler 48 oder der Windparkregler 28 eingerichtet sein, entsprechende Stellsignale bereitzustellen. Die Bereitstellung kann so zum Beispiel auf die tatsächliche Blindleistungseinspeisung der Windenergieanlagen bzw. des Windparks und den tatsächlichen Fehlerverlauf bzw. den Spannungsverlauf während des Netzfehlers angepasst werden. Die übergeordneten Regler können also das Verhalten der Phasenregelschleife entsprechend verschiedener Phasen des Netzfehlers anpassen, wobei durch die Spannungsabhängigkeit der Funktionen bzw. Kennlinien auch nach dieser Vorgabe eine dynamische Anpassung der PLL-Parameter über einen weiten Bereich möglich ist.

Figur 4 zeigt auf der linken Seite mögliche Kennlinienverläufe für den PLL-Parameter T₁ des PT₁-Glieds 64 in Abhängigkeit von der Mitsystemspannung U_{LV}⁺, wie sie in dem Block 78 vorgegeben sein können, und auf der rechten Seite mögliche Kennlinienverläufe für den PLL-Parameter K_{P} des P-Glieds 62 in Abhängigkeit von der Mitsystemspannung U_{LV}⁺, wie sie in dem Block 76 vorgegeben sein können. Die Mitsystemspannung ist dabei als Prozentwert bezogen auf ihren Nennwert U_{N} aufgetragen. Für den PLL-Parameter T₁ wurde eine prozentuale Darstellung bezogen auf einen vorgegebenen Parameter T_{1,N} gewählt, der mittels einer hinterlegten Funktion skaliert wird. Für den PLL-Parameter K_{P} ist eine prozentuale Darstellung bezogen auf einen vorgegebenen Parameter K_{P,N} gewählt, der ebenfalls mittels einer hinterlegten Funktion skaliert wird.

Der PLL-Parameter T₁ des PT₁-Glieds 64 besitzt im Bereich von 0 bis 20% der Mitsystemspannung nur eine geringe Steigung und im Wesentlichen konstante sehr hohe Werte. Für eine Mitsystemspannung von 100 bis 120% besitzt der Parameter ebenso nur eine geringe Steigung und im Wesentlichen einen konstanten Wert von etwa T_{1,N}. In einem Bereich von etwa 20 bis 50% der Mitsystemspannung weisen die Kennlinien einen starken Anstieg auf. Die durchgezogene Kennlinie ändert das Verhalten des PT₁-Elements erst bei tieferen Spannungsfehlern als die gepunktet dargestellte Kennlinie.

Der PLL-Parameter K_{P} des P-Glieds 62 weist in den Bereichen von 0 bis etwa 20% und von 100 bis 120% der Mitsystemspannung ebenso nur eine geringe Steigung und im Wesentlichen einen konstanten Wert von etwa K_{P} auf. In einem Übergangsbereich zwischen 20% und 100% der Mitsystemspannung sind die Kennlinienverläufe derart gewählt, dass diese einen Wendepunkt aufweisen. Der Anstieg der Kennlinien in dem Wendepunkt charakterisiert das Verhalten des P-Glieds in dem Übergangsbereich. Der Verlauf der Kurven ist glatt und monoton. In Abhängigkeit der Netzeigenschaften können die Bereiche der unterschiedlichen Anstiege in ihrer Breite und in ihren Verläufen abweichen.

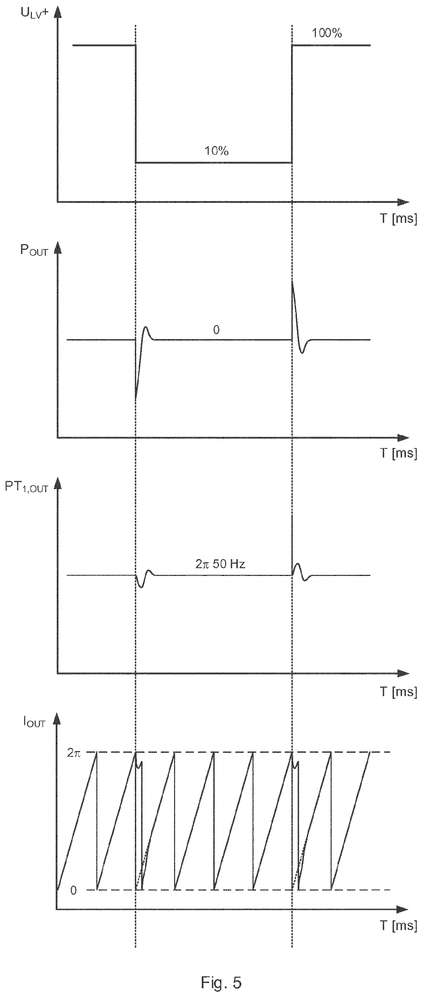

Figur 5 zeigt das zeitliche Verhalten der PLL 58 abhängig von der Mitsystemspannung aufgelöst. Dargestellt ist der Fall in dem die Mitsystemspannung U_{LV}+ von einem Wert mit 100% der Nennspannung U_{N} für eine durch den hier simulierten Netzfehler bestimmte Zeitdauer auf einen Wert von 10% fällt. Danach springt die Mitsystemspannung von 10% zurück auf den Nennwert mit 100%.

Das Proportionalglied 62 greift auf die Regeldifferenz aus φ_{Line} und φ_{PLL} zurück. Ist die PLL vor einem Einbruch der Mitsystemspannung eingeschwungen, so ist die Ausgangsgröße des P-Gliedes 62 null. Im Falle der Spannungseinbuße auf 10% wird der Parameter K_{P} auf null oder einen sehr kleinen Wert gesetzt. Der Ausgang des P-Gliedes 62 P_{OUT} zeigt dabei den in Figur 5 beispielhaft dargestellten Verlauf, bei dem es zu einem Absenken des P-Werts mit einem kleinen Überschwinger kommt, bevor wieder die Ausgangsgröße 0 ausgegeben wird. Ein ähnliches zeitliches Verhalten zeigt das P-Glied 62 bei der Rückkehr der Mitsystemspannung und ihrem Sprung von 10% auf 100%.

Einen sehr ähnlichen Verlauf zeigt auch die Ausgangsgröße des PT₁-Gliedes 64 PT_{1,OUT} bei dem es mit den Spannungssprüngen ebenfalls zu kleinen Überschwingern kommt.

Von Interesse ist hier im besonderen Maße die Ausgangsgröße des Integrators 74 I_{OUT}. Diese zeigt, dass der Phasenwinkel während des Spannungseinbruchs linear mit der Zeit weiter läuft. Lediglich die beiden Phasensprünge führen zu einer Änderung der Phase im nachfolgenden Zyklus.

Das vorstehende Ausführungsbeispiel stellt ausschließlich auf eine Bewertung der Spannung im Mitsystem ab. Grundsätzlich wäre auch eine Betrachtung des Gegensystems möglich. Es ließe sich für die Gegensystemspannung in der Steuerung eine Kurvenschar hinterlegen, die die eine Kurve abhängig von einer weiteren Größe bestimmt, die den Zustand des Einspeisenetzes berücksichtigt. So könnte beispielsweise eine Netzimpedanz und/oder der induktive oder kapazitive Anteil des eingespeisten Stroms oder der Leistung berücksichtigt werden. Auch könnte auf eine Änderungsgeschwindigkeit des Spitzen- oder Effektivwerts der Netzspannung abgestellt werden.

## Patentansprüche

1. Verfahren zum Betrieb einer Windenergieanlage (10) mit einer doppelt gespeisten Asynchronmaschine (38), die mittels eines Umrichters (42, 44) in ein elektrisches Versorgungsnetz elektrische Leistung synchronisiert zu einer Netzspannung einspeist, **dadurch gekennzeichnet, dass** das Verfahren folgende Schritte aufweist:
- Messen einer Spannung in dem elektrischen Versorgungsnetz (32) und deren Phasenwinkel (φₗᵢₙₑ),
- Bestimmen des Werts von mindestens einem Parameter (K_{P}, Tₗ) für eine Phasenregelschleife (PLL) (58) abhängig von der gemessenen Spannung,
- Einstellen des mindestens einen Parameters (K_{P}, T₁) an der Phasenregelschleife (PLL) (58),
- Bestimmen eines korrigierten Phasenwinkels (φ_{PLL}) mittels der eingestellten Phasenregelschleife (PLL) abhängig von dem gemessenen Phasenwinkel (φₗᵢₙₑ) aus dem elektrischen Versorgungsnetz (32) und
- Ansteuern des Umrichters (42, 44) mit dem korrigierten Phasenwinkel (φ_{PLL}) als Sollwert für den netzsynchronen Betrieb,
- wobei die Phasenregelschleife (PLL) (58) einen proportionalen Schleifenfilter (62) mit einer Proportionalitätskonstante (K_{P}) als den mindestens einen Parameter aufweist, deren Wert spannungsabhängig bestimmt wird und/oder die Phasenregelschleife (PLL) (58) einen Tiefpassfilter mit einer Zeitkonstanten (T₁) als den mindestens einen Parameter aufweist, deren Wert spannungsabhängig bestimmt wird.

2. Verfahren nach Anspruch 1, **dadurch gekennzeichnet, dass** der mindestens eine Parameter (K_{P}, T₁) die Dynamik der Phasenregelschleife (PLL) (58) bestimmt.

3. Verfahren nach Anspruch 2, **dadurch gekennzeichnet, dass** der mindestens eine Parameter eine Spannungsabhängigkeit dahingehend besitzt, dass im Falle eines Spannungseinbruchs ein Betrieb der Phasenschleife mit verlangsamter Dynamik möglich ist.

4. Verfahren nach Anspruch 3, **dadurch gekennzeichnet, dass** eine Netzkreisfrequenz (ω) mittels eines Differentialglieds (D-Glied) (66) aus dem gemessenen Phasenwinkel (φₗᵢₙₑ) bestimmt wird und an einem Totzeitglied (PTₜ) (68) anliegt, das eingerichtet ist, die Netzkreisfrequenz (ω) verzögert für die Berechnung des Phasenwinkels bereitzustellen, wobei das Ausgangssignal des Totzeitgliedes (PTₜ) (68) an einem Verzögerungsglied (PT₁-Glied) (64) mit einem proportionalen Übertragungsverhalten und einer Verzögerung erster Ordnung anliegt.

5. Verfahren nach einem der Ansprüche 1 bis 4, **dadurch gekennzeichnet, dass** die Proportionalitätskonstante K_{P} im Fall eines Netzfehlers einen Wert von nahezu Null annimmt.

6. Verfahren nach einem der Ansprüche 1 bis 5, **dadurch gekennzeichnet, dass** die Zeitkonstante T₁ im Fall eines Netzfehlers einen stark überhöhten Wert annimmt.

7. Verfahren nach einem der Ansprüche 1 bis 6 **dadurch gekennzeichnet, dass** der Netzfehler einen Spannungseinbruch umfasst, bei dem die Spannung auf einen Wert von 15 % der Nennspannung oder weniger fällt.

8. Verfahren nach einem der Ansprüche 1 bis 7, **dadurch gekennzeichnet, dass** der wenigstens eine Parameter als stetige Funktion in Abhängigkeit von der Spannung vorgegeben ist.

9. Verfahren nach einem der Ansprüche 1 bis 8, **dadurch gekennzeichnet, dass** der Wert des mindestens einen Parameters spannungsabhängig zwischen einem Minimalwert und einem Maximalwert verläuft.

10. Verfahren nach einem der Ansprüche 1 bis 9, **dadurch gekennzeichnet, dass** die Phasenregelschleife ein Totzeitglied mit einer einstellbaren Totzeit Tₜ aufweist.

11. Verfahren nach einem der Ansprüche 1 bis 10, **dadurch gekennzeichnet, dass** der Spannungswert die Mitsystemspannung (U_{LV}⁺) oder die Gegensystemspannung ist.

12. Verfahren nach einem der Ansprüche 1 bis 11, **dadurch gekennzeichnet, dass** das Verfahren kontinuierlich ausgeführt wird.

## Claims

1. A method for operating a wind turbine (10) having a double-fed induction machine (38) that feeds electrical power into an electrical supply network by means of a converter (42, 44) in a manner synchronized with a network voltage, **characterized in that** the method comprises the following steps:
- measuring a voltage in the electrical supply network (32) and the phase angle (φₗᵢₙₑ) thereof,
- determining the value of at least one parameter (K_{P}, T₁) for a phase-locked loop (PLL) (58) depending on the measured voltage,
- setting the at least one parameter (K_{P}, T₁) at the phase-locked loop (PLL) (58),
- determining a corrected phase angle (φ_{PLL}) by means of the set phase-locked loop (PLL) depending on the measured phase angle (φₗᵢₙₑ) from the electrical supply network (32), and
- actuating the converter (42, 44) with the corrected phase angle (φ_{PLL}) as the target value for network-synchronous operation,
- wherein the phase-locked loop (PLL) (58) comprises a proportional loop filter (62) with a proportionality constant (K_{P}) as the at least one parameter, the value of which is determined in a voltage-dependent manner, and/or the phase-locked loop (PLL) (58) comprises a low-pass filter with a time constant (T₁) as the at least one parameter, the value of which is determined in a voltage-dependent manner.

2. The method according to claim 1, **characterized in that** the at least one parameter (K_{P}, T₁) determines the dynamics of the phase-locked loop (PLL) (58).

3. The method according to claim 2, **characterized in that** the at least one parameter has a voltage dependence to the effect that it is possible to operate the phase loop with slower dynamics in the event of a voltage drop.

4. The method according to claim 3, **characterized in that** a network angular frequency (ω) is determined from the measured phase angle (φₗᵢₙₑ) by means of a derivative element (D element) (66) and is applied to a dead-time element (PTₜ) (68), which is configured to provide the network angular frequency (ω) for the phase angle calculation with a delay, wherein the output signal of the dead-time element (PTₜ) (68) is applied to a delay element (PT₁ element) (64) with proportional transfer characteristics and a first-order delay.

5. The method according to one of claims 1 to 4, **characterized in that** the proportionality constant K_{P} assumes a value of almost zero in the event of a network fault.

6. The method according to one of claims 1 to 5, **characterized in that** the time constant T₁ assumes a greatly increased value in the event of a network fault.

7. The method according to one of claims 1 to 6, **characterized in that** the network fault includes a voltage drop in which the voltage drops to a value of 15% of the rated voltage or lower.

8. The method according to one of claims 1 to 7, **characterized in that** the at least one parameter is predefined as a continuous function depending on the voltage.

9. The method according to one of claims 1 to 8, **characterized in that** the value of the at least one parameter varies in a voltage-dependent manner between a minimum value and a maximum value.

10. The method according to one of claims 1 to 9, **characterized in that** the phase-locked loop comprises a dead-time element with an adjustable dead time Tₜ.

11. The method according to one of claims 1 to 10, **characterized in that** the voltage value is the positive-sequence system voltage (U_{LV}⁺) or the negative-sequence system voltage.

12. The method according to one of claims 1 to 11, **characterized in that** the method is carried out continuously.

## Revendications

1. Procédé de fonctionnement d'une éolienne (10) comprenant une machine asynchrone à double alimentation (38), laquelle injecte de la puissance électrique synchronisée avec une tension de réseau, au moyen d'un convertisseur (42, 44), dans un réseau d'alimentation électrique, **caractérisé en ce que** le procédé comprend les étapes suivantes :
- mesure d'une tension dans le réseau d'alimentation électrique (32) et de son angle de phase (φₗᵢₙₑ),
- détermination de la valeur d'au moins un paramètre (K_{P}, T₁) pour une boucle à verrouillage de phase (PLL) (58) en fonction de la tension mesurée,
- réglage de l'au moins un paramètre (K_{P}, T₁) au niveau de la boucle à verrouillage de phase (PLL) (58),
- détermination d'un angle de phase corrigé (φ_{PLL}) au moyen de la boucle à verrouillage de phase (PLL) réglée, en fonction de l'angle de phase mesuré (φₗᵢₙₑ) à partir du réseau d'alimentation électrique (32) et
- actionnement du convertisseur (42, 44) avec l'angle de phase corrigé (φ_{PLL}) comme valeur de consigne pour un fonctionnement synchronisé avec le réseau,
- dans lequel la boucle à verrouillage de phase (PLL) (58) présente un filtre de boucle proportionnel (62) ayant une constante de proportionnalité (K_{P}) en tant que l'au moins un paramètre, dont la valeur est déterminée en fonction de la tension, et/ou la boucle à verrouillage de phase (PLL) (58) présente un filtre passe-bas ayant une constante de temps (T₁) en tant que l'au moins un paramètre, dont la valeur est déterminée en fonction de la tension.

2. Procédé selon la revendication 1, **caractérisé en ce que** l'au moins un paramètre (K_{P}, T₁) détermine la dynamique de la boucle à verrouillage de phase (PLL) (58).

3. Procédé selon la revendication 2, **caractérisé en ce que** l'au moins un paramètre présente une dépendance vis-à-vis de la tension, de telle sorte qu'en cas de chute de tension, un fonctionnement de la boucle de phase avec une dynamique ralentie est possible.

4. Procédé selon la revendication 3, **caractérisé en ce qu'**une pulsation du réseau (ω) est déterminée au moyen d'un élément différentiel (élément D) (66) à partir de l'angle de phase mesuré (φₗᵢₙₑ) et est appliquée à un élément à temps mort (PTₜ) (68), lequel est configuré pour fournir la pulsation du réseau (ω) avec un retard pour le calcul de l'angle de phase, dans lequel le signal de sortie de l'élément à temps mort (PTₜ) (68) est appliqué à un élément de retard (élément PT₁) (64) présentant un comportement de transmission proportionnel et un retard de premier ordre.

5. Procédé selon l'une des revendications 1 à 4, **caractérisé en ce que** la constante de proportionnalité K_{P} prend une valeur proche de zéro en cas de défaut du réseau.

6. Procédé selon l'une quelconque des revendications 1 à 5, **caractérisé en ce que** la constante de temps (T₁) prend une valeur fortement augmentée en cas de défaut du réseau.

7. Procédé selon l'une des revendications 1 à 6, **caractérisé en ce que** le défaut du réseau comporte une chute de tension au cours de laquelle la tension chute à une valeur de 15 % de la tension nominale ou moins.

8. Procédé selon l'une des revendications 1 à 7, **caractérisé en ce que** l'au moins un paramètre est prédéfini comme une fonction continue dépendant de la tension.

9. Procédé selon l'une des revendications 1 à 8, **caractérisé en ce que** la valeur de l'au moins un paramètre varie en fonction de la tension entre une valeur minimale et une valeur maximale.

10. Procédé selon l'une des revendications 1 à 9, **caractérisé en ce que** la boucle à verrouillage de phase présente un élément à temps mort avec un temps mort réglable Tₜ.

11. Procédé selon l'une des revendications 1 à 10, **caractérisé en ce que** la valeur de tension est la tension de séquence directe (U_{LV}⁺) ou la tension de séquence inverse.

12. Procédé selon l'une des revendications 1 à 11, **caractérisé en ce que** le procédé est exécuté en continu.
